Europäisches Patentamt

European Patent Office

Office européen des brevets

(11) Publication number: **0 089 044**
**B1**

## EUROPEAN PATENT SPECIFICATION

(45) Date of publication of patent specification: **28.02.90**

(21) Application number: **83102496.3**

(22) Date of filing: **14.03.83**

(51) Int. Cl.⁵: **H 01 L 23/10** // H01L23/04, H01L31/02

(54) A semiconductor device having a container sealed with a solder of low melting point.

(30) Priority: **16.03.82 JP 41050/82**

(43) Date of publication of application:
**21.09.83 Bulletin 83/38**

(45) Publication of the grant of the patent:
**28.02.90 Bulletin 90/09**

(84) Designated Contracting States:
**DE FR GB**

(56) References cited:
**US-A-3 621 564**
**US-A-4 076 955**

**PATENTS ABSTRACTS OF JAPAN, vol. 5, no. 51,
(E-51) 723r, April 10, 1981; & JP - A - 56 42 61
(NIPPON DENKI K.K.) 17-01-1981**

**PATENTS ABSTRACTS OF JAPAN, vol. 6, no. 42,
(E-98) 920r, March 16, 1982; & JP - A - 56 158 458
(MATSUSHITA DENKI SANGYO K.K.) 07-12-1981**

(73) Proprietor: **NEC CORPORATION
33-1, Shiba 5-chome, Minato-ku
Tokyo 108 (JP)**

(72) Inventor: **Okano, Kazuo
Nippon Electric Co., Ltd. 33-1, Shiba Gochome
Minato-ku Tokyo (JP)**

(74) Representative: **Glawe, Delfs, Moll & Partner
Patentanwälte
Postfach 26 01 62 Liebherrstrasse 20
D-8000 München 26 (DE)**

## Description

The present invention relates to a method for manufacturing a semiconductor device including steps of mounting a semiconductor element (13) on a base member (12) having a wall member (12') surrounding said semiconductor element, attaching a first frame (17) to said wall member by a metallic soldering material (18) and attaching a cap member (11) to said first frame.

Recently, imaging elements using a charge coupled device (i.e., CCD), a photo-detector array, or an MOS-transistor array have been developed. A container for such an imaging element must have a window with an optically transparent plate of sapphire or glass. However, no metallized layer can be formed on the surface of sapphire or glass plate, so that metallic solders having a small water vapor permeability and a low melting point cannot be used to hermetically attach the window glass to the package. Other than metallic solders, solder glass or resin solder could be used. Despite this, the imaging element has an optical filter made of an organic material formed over its surface. Since the properties of an optical filter are subjected to change at a temperature not so high, the use of solder glass which is processed at a temperature around 400°C would deteriorate the optical filter. On the other hand, some resin solder have a low melting point of 150°C, but they have a relatively high water vapor permeability so that ambient moisture can penetrate the container, after the semiconductor element has been sealed into the container, thereby deteriorating the characteristics of the semiconductor element.

The container in the prior art has another defect that the positional relationship between the cover member and the wall member is liable to be displaced when the cover member is fixed to the wall member, thereby reducing the production yield.

A further semiconductor device incorporating implicitly the method steps of the first portion of claim 1 is known from Patents Abstract of Japan, Vol. 5, No. 51 (E-51) (723) April 10, 1987 which corresponds to Japanese patent publication No. 56-4261. However, this known semiconductor device is concerned with a non-optical semiconductor device.

It is, therefore, a primary object of the present invention to provide a method for manufacturing a semiconductor device having a container which can safely seal an optical semiconductor element having a low heat resistance.

Another object of the manufacturing method of present invention is to provide a semiconductor device having a container, which has excellent hermetic properties, and which can be fabricated with a high yield.

These objects according to the invention are solved by the features, that said semiconductor element is a photosensitive element and said cap member is made of glass or sapphire and that said first frame is previously attached to said cap member by a glassy adhesive before being attached to said wall member and hermetic sealing is made by attachment of said first frame to said wall member with said metallic soldering material.

In a preferred embodiment of the invention a second frame is previously attached to an outer portion of the upper surface of said wall member and said first frame is attached to the inner portion of the upper surface of said wall member by filling a gap between said first and second frames with said metallic soldering material.

According to the present invention, metallic soldering materials which may have a low melting point can be used, and the container can be sealed at a sufficiently low temperature. In more detail, the cap member and the intermediate member are attached in advance by the solder glass. The semiconductor element is mounted on the mounting area of the container main body, followed by a necessary wiring, etc. After those, the assembly of the cap member and the intermediate member is attached to the container main body by the metallic soldering material having a low melting point, to hermetically seal semiconductor element in the container. Therefore, the semiconductor element is not damaged thermally.

The solder glass and the metallic solder can withstand the water vapor permeance, preventing moisture from penetrating from the atmosphere. In other words, the hermetic properties are excellent, because of non-use of resin adhesives. Thanks to the formation of the protrusion on the container main body, moreover, the passage by which the moisture may penetrate through the metallic soldering material is bent and elongated. As a result, the hermetic properties of the container are further improved.

Another effect is caused by the presence of the protrusion on the container main body. The production yield can be increased because there is no positional displacement between the container main body and the cap member. The presence of that protrusion makes it remarkably easy to determine the position of the cap member on the container body and fix their relationship during the sealing step using the metallic soldering material, thereby increasing the fabrication efficiency.

Brief Description of the Drawings

The above and other objects, features and advantages of the present invention will be explained more fully in the following detailed description taken in conjunction with the accompanying drawings, wherein:

Fig. 1 is a sectional view showing a semiconductor device in the prior art;

Fig. 2 is a sectional view showing a first embodiment;

Fig. 3 is a partial sectional view showing the essential parts of Fig. 2 in an enlarged scale;

Fig. 4 is a partial sectional view showing a shortcoming of the first embodiment;

Fig. 5 is a partial sectional view showing the essential parts of a modification of the first embodiment;

Fig. 6 is a sectional view showing a second embodiment;

Fig. 7 is a partial sectional view showing the essential parts of Fig. 6 in an enlarged scale; and

Fig. 8 is a sectional view showing a third embodiment.

Prior Art

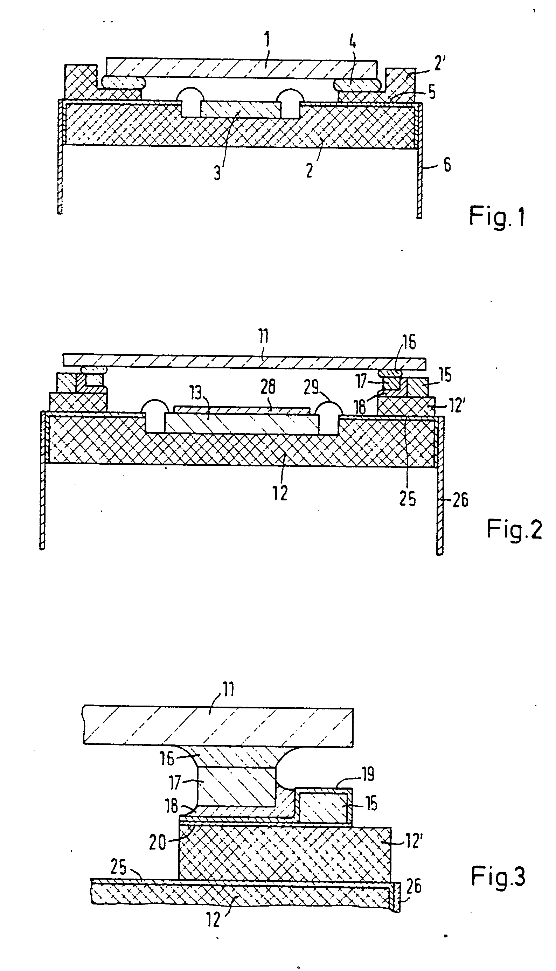

Before entering into a detailed description of the invention, a cursory review of the prior art will be made with reference to Fig. 1. A container is made of a container body and a cap member 1. The container body made of ceramic is constructed of a base member 2 and a wall member 2', which are integrally combined by sintering ceramic sheets together with metallic layers 5 which are used for leading out the electrodes of a semiconductor element 3. These metallic layers 5 are formed up to the sides of the base member 2. External leads 6 are soldered or welded to the metallic layers 5. The base member 2 has a recess on which the semiconductor element 3 such as a linear image sensor element requiring no filter is soldered. The electrodes of this semiconductor element 3 are electrically connected to the metallic layers 5 by the wire bonding method.

After this construction has been completed, a cap member 1 made of transparent glass or sapphire is attached to the wall member 2' of the container main body by an adhesive 4. The adhesive 4 is, for example, a solder glass having a low melting point. In this case, the cap member 1 is attached at a temperature of about 400°C. This temperature does not damage the semiconductor element itself, but damages a resin filter which is placed over the semiconductor element such as an area image sensor.

If a resin solder is alternatively used as the adhesive 4, the sealing temperature could be lowered to 150°C to prevent the above shortcoming. But it brings another shortcoming that moisture penetrates the resin adhesive from the outside to induce the deterioration of the semiconductor element 4, etc. In other words, the resin solder has inferior hermetic properties against water vapor so that moisture will penetrate the container through the resin adhesive if the semiconductor device is used in a hot and humid atmosphere after it has been sealed.

Description of the Preferred Embodiments

Embodiment 1

The container shown in Fig. 2 is first prepared in two separate parts, a base assembly and a cap assembly. The base assembly is constructed of a base member 12 having a recess in its center, and a wall member 12', which are integrated together with metallized wiring layers 25. For the formation of the base assembly, green sheet of alumina ceramic is formed into shapes of the base member 12 and the wall member 12'. On the green sheet of the base member 12, tungsten is metallized and nickel is plated on the metallized tungsten to form the wiring layers 25. The wiring layers 25 are extended to the side walls of the base member 12 where external leads 26 are to be soldered. The green sheet of the wall member 12' is piled on the green sheet of the base member having the wiring layers to be integrally combined by sintering.

After the sintering process, as shown in detail in Fig. 3, a metallized layer of tungsten and a layer of nickel plated on the metallized layer are formed on the upper surface of the wall member 12' to form a metal layer 20.

A metal frame 15 made of an alloy of nickel, cobalt and iron, is soldered to the metal layer 20 by a metallic soldering material having a relatively high melting point. As the metallic soldering material, an alloy of silver and copper (a melting point of 779°C to 870°C), silver (a melting point of 961°C) or copper (a melting point of 1083°C) is preferably employed. The metal frame 15 used has a height of 0.2 mm to 0.7 mm and a width of 0.3 mm to 1.0 mm. The metal frame 15 may either be formed all around the periphery of the wall member 12', or be arranged with some parts removed, i.e., in the shape of a broken line.

The exposed surface of the metal layer 20 and the surface of the metal frame 15 are plated with a layer 19 of gold or another metal selected from the group of metals having an excellent wettability with a metallic soldering material 18 such as tin, copper and silver.

On the other hand, the cap assembly is made of the cap member 11 and the metal frame 17. The metal frame 17 is made of an alloy of nickel, cobalt and iron or an alloy of iron and nickel and attached to a cap member 11 made of sapphire or transparent glass by a solder glass 16 such as a glass of $PbO-B_2O_3$ system. The metal frame 17 thus attached is positioned at a slight distance from the inner side wall of the metal frame 15. The solder glass has a softening point between 300°C and 350°C. Therefore, the soldering process is conducted at a temperature of 400°C to 500°C and in a nitrogen atmosphere.

Since the formation of the two assemblies thus far described are conducted before a semiconductor element 13 is mounted, the respective assemblies can be made at relatively high soldering temperatures. Therefore, solders having little water vapor permeability can be selected. The metal solder used for soldering the metal frame 15 and the metal layer 20 and the solder glass used for soldering the cap member 11 and the metal frame 17 have very little water vapor permeabilities.

After that, a semiconductor element such as a CCD area image sensor, which has a resin filter 28 over its surface, is soldered into the recess of the base member 12. The electrodes of the semiconductor element 13 are electrically connected to the wiring layers 25 by fine metal wires 29. Thereafter, the assembly of the cap member 11 and the metal frame 17 prepared in the above manner is laid on and soldered to the wall member 12' by metallic soldering material 18.

This soldering process is conducted in a nitrogen atmosphere at 170°C using indium which has a melting point of 157°C. In the present example, the metal frame 17 is positioned inside the metal frame 15. In place of the indium solder, alloys of indium and gallium (a melting point of 154°C), tin and indium (a melting point of 130°C), indium, tin and lead (a melting point of 162°C) or indium and silver (a melting point of 143°C) may be employed.

According to the construction thus far described, since the soldering process can be conducted at a temperature of at most 200°C after the semiconductor element 13 has been mounted on the base member 12, the resin filter 28 placed over the semiconductor element 13 is not damaged.

Moreover, since the metal frames 17 and 15 are laterally overlapped in the final construction, the passage of moisture from the outside to the inside of the container, which is via the metallic soldering material 18, is bent and elongated. As a result, the airtightness is further improved to prevent the characteristics of the semiconductor element 13 from deteriorating due to the penetration of moisture.

The metal frame 15 can provide a reference for alignment when the cap member 11 is laid on and attached to the wall member 12', thereby facilitating the positioning process. In more detail, the relative positions of the cap member 11 and the wall member 12' are liable to be displaced when the metallic soldering material 18 is heated and melted. Since, however, the metal frame 15 has already been attached to the wall member 12', the relationship of the positions is unchanged. Thus, the semiconductor element can be sealed into the container hermetically with a high yield.

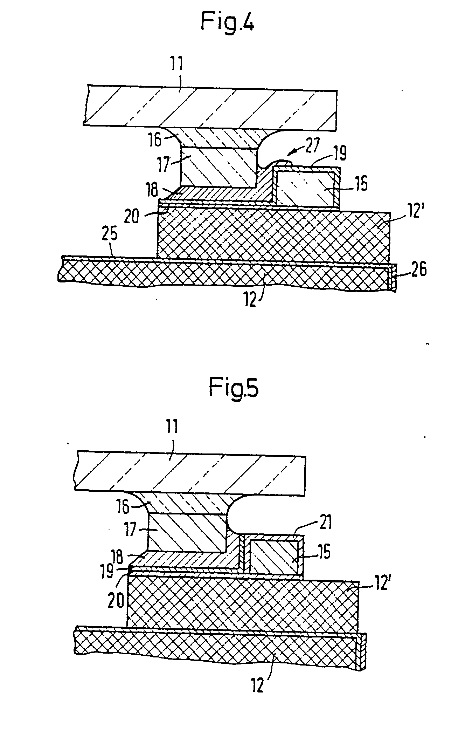

In the example thus far described, a problem may arise, not in the electric characteristics, but in the appearance. As shown in Fig. 4, specifically, some metallic soldering material 17 could flow up over the surface of the metal frame 15. This is caused because the gold-plated layer 19, which has an excellent wettability with the metallic soldering material 27, also covers the upper face of the metal frame 15.

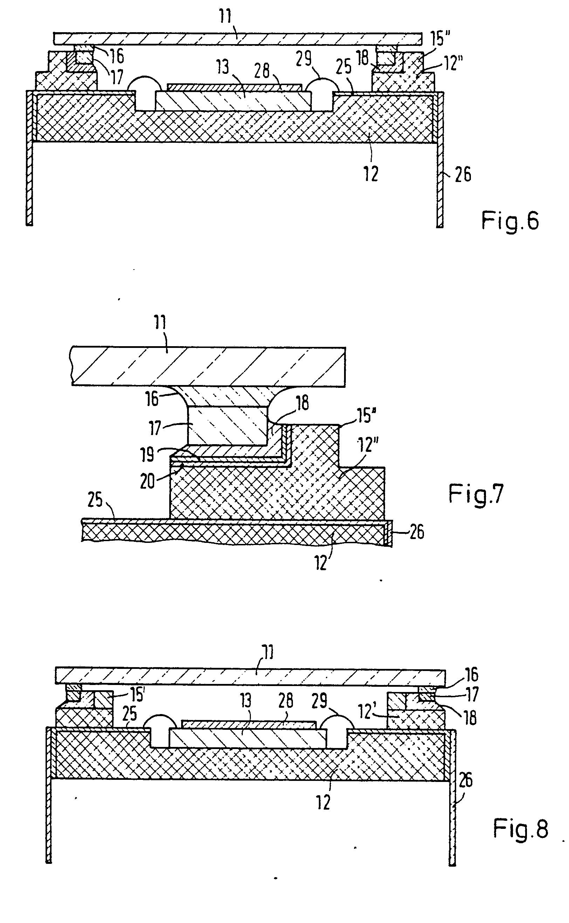

The embodiment shown in Fig. 3 can be modified to prevent this deterioration of the appearance, as shown in Fig. 5. The metal frame 15 has its surface plated with a metal layer 21 having a poor wettability with the metallic soldering material 18, for example, nickel, aluminum, chromium or titanium. Moreover, the metal-plated layer 19 with the excellent wettability with the metallic soldering material 18 is limited to the surface of the metal layer 20 and the surface of the plated layer 21 on the inner side of the metal frame 15. Thus, the metallic soldering material 18 is prevented to extend onto the upper surface of the metal frame 15 thereby eliminating the problem of the bad appearance.

*Embodiment 2*

Referring to Figs. 6 and 7, a wall member 12'' of this embodiment has a projection 15'' corresponding to the metal frame 15 of the Embodiment 1. This projection 15'' is made of the same material, e.g. alumina ceramic, as the wall member 12''. According to one method of fabrication, green sheet of alumina ceramic is shaped into two parts which are integrated with the base member 12 by a sintering process. A tungsten-metallized and nickel-plated layer 20 whose surface is plated with gold (19) is limited to the surface facing the metal frame 17. The other parts are constructed similarly to the Embodiment 1.

The fabrication can thus be simplified with the characteristics of the device of embodiment 1 unchanged. Further, ceramics have an intrinsically bad wettability with the metallic soldering material 18. This fact causes no problems of bad appearance due to the extrusion of metallic soldering material.

This means that, the material forming the frame 15 (as shown in Figs. 3 and 5) is not limited to a metallic one, but may be an insulating one such as a ceramic. If the frame 15 is made of such a material that has a bad wettability with the metallic soldering material 18, at least the part facing the metal frame 17 has to be formed with a surface layer having an excellent wettability with the metallic soldering material 18.

*Embodiment 3*

According to this embodiment, as shown in Fig. 8, a metal frame 15' is positioned inside the metal frame 17, while the rest of the construction is identical to that of embodiment 1. The metal frame 15' is made of an alloy of nickel, cobalt and iron. Although not shown in detail in Fig. 8, the surfaces of the wall member 12' and the metal frame 15' have metal layers similar to the layers 19 and 20 of Fig. 3 or the layers 19, 20 and 21 of Fig. 5. The metal frame 15' is soldered to the metal layer 20 (not shown in Fig. 8 but refer to Figs. 3 and 5) on the wall member 12' made of alumina ceramic. The exposed portion of the metal layer 20 (refer to Fig. 3) and the metal frame 15' are covered with the gold-plated layer 19 (refer to Fig. 3), or after the surface of the metal frame 15' is plated with nickel 21 (refer to Fig. 5), the surfaces of the metal layer 20 (refer to Fig. 5) and the metal frame 15' facing the metal frame 17 are covered with the gold-plated layer 19 (refer to Fig. 5). The easy alignment of the metal frame 17 with the metal frame 15' and the reliable airtightness are obtained similarly to the Embodiments 1 and 2.

The above description has been made with the semiconductor element exemplified by an area image sensor on which a resin filter is formed over the semiconductor chip. However, the semiconductor element can also be exemplified by an erasable and programmable read-only memory (i.e., EPROM) which can receive the irradiation of ultraviolet light through the transparent cover plate when its memory contents are to be erased.

Moreover, the present invention can be applied to other optical semiconductor elements.

## Claims

1. A method for manufacturing a semiconductor device including steps of mounting a semiconductor element (13) on a base member (12) having a wall member (12') surrounding said semiconductor element, attaching a first frame (17) to said wall member by a metallic soldering material (18) and attaching a cap member (11) to said first frame, characterized in that said semiconductor element (12) is a photosensitive element and said cap member (11) is made of glass or sapphire and that said first frame is previously attached to said cap member by a glassy adhesive (16) before being attached to said wall member (12') and hermetic sealing is made by attachment of said first frame to said wall member with said metallic soldering material.

2. The method of claim 1, characterized in that a second frame (15) is previously attached to an outer portion of the upper surface of said wall member and said first frame is attached to the inner portion of the upper surface of said wall member by filling a gap between said first and second frames with said metallic soldering material.

## Patentansprüche

1. Verfahren zum Herstellen einer Halbleiteranordnung mit den Schritten, ein Halbleiterelement (13) auf ein Unterteil (12) mit einem das Halbleiterelement umgebenden Wandelement (12') anzubringen, einen ersten Rahmen (17) an dem Wandelement durch ein metallisches Lötmaterial (18) zu befestigen und ein Abdeckteil (11) an dem ersten Rahmen zu befestigen, dadurch gekennzeichnet, daß das Halbleiterelement (12) ein fotoempfindliches Element ist und das Abdeckteil (11) aus Glas oder Saphir hergestellt wird, und daß der erste Rahmen vorher an dem Abdeckteil durch ein glasiges Haftmittel (16) befestigt wird, bevor es an dem Wandelement (12') befestigt wird und eine hermetische Abdichtung durch Befestigung des ersten Rahmens an dem Wandelement mit dem metallischen Lötmaterial erzeugt wird.

2. Verfahren nach Anspruch 1, dadurch gekennzeichnet, daß ein zweiter Rahmen (15) vorher an einem äußeren Bereich der oberen Fläche des Wandelements befestigt wird und der erste Rahmen an dem inneren Bereich der oberen Fläche des Wandelements befestigt wird, indem eine Spalte zwischen dem ersten und dem zweiten Rahmen mit dem metallischen Lötmaterial ausgefüllt wird.

## Revendications

1. Procédé pour fabriquer un dispositif à semi-conducteur, comprenant les étapes consistant à monter un élément en semi-conducteur (13) sur un élément de base (12) ayant un élément de paroi (12') entourant l'élément en semi-conducteur, à fixer un premier cadre (17) à l'élément de paroi par une soudure métallique (18) et à fixer un élément de coiffe (11) sur le premier cadre, caractérisé en ce que l'élément en semi-conducteur (12) est un élément photosensible et l'élément de coiffe (11) est en verre ou en saphir et en ce que le premier cadre est tout d'abord fixé à l'élément de coiffe par un adhésif vitreux (16) afin d'être assujetti à l'élément de paroi (12') et le scellement hermétique est exécuté par fixation du premier cadre à l'élément de paroi avec la soudure métallique.

2. Procédé selon la revendication 1, caractérisé en ce qu'un second cadre (15) est antérieurement fixé à une portion extérieure de la surface supérieure de l'élément de paroi et le premier cadre est assujetti à la portion intérieure de la surface supérieure de l'élément de paroi en remplissant l'interstice séparant les premier et second cadres avec la soudure métallique.

EP 0 089 044 B1

Fig. 1

Fig. 2

Fig. 3

1

## Fig.4

## Fig.5

Fig.6

Fig.7

Fig.8